# EUROPEAN PATENT APPLICATION

(11) **EP 4 672 885 A1**
(43) Date of publication of application: **31.12.2025**
(21) Application number: 24306059.7
(22) Date of filing: 28.06.2024
(51) Int. Cl.: H05K 7/20

(54) **OPTIMIZED EVAPORATIVE DRY COOLING ARRANGEMENT FOR A DATACENTER**

(71) Applicant: OVH, 59100 Roubaix (FR)
(72) Inventor: CHEHADE, Ali, 59283 Moncheaux (FR); HNAYNO, Mohamad, 59100 Roubaix (FR)
(74) Representative: BCF Global

(57) **Abstract**

A datacenter dry cooling system and method for cooling a heat-generating source are provided. The configuration includes an evaporating pad disposed on an air-to-liquid heat exchanger panel and an evaporating cooling water distribution arrangement for applying a controlled measured amount cooling water to the evaporating pad. The applied water serves is to be evaporated while the evaporating pad is exposed to ambient airflow to dissipate thermal energy of warmed liquid received from the heat-generating sources. The evaporating pad incorporates at least one of a temperature sensor or a humidity sensor for detecting outside temperature or humidity levels. A controller communicatively-coupled to the temperature or humidity sensor controls the volume flow of the cooling water based on the detected temperature or humidity levels.

## Description

### FIELD

The present technology generally relates to the field of datacenter cooling measures and, in particular, to an evaporative cooling arrangement for a dry cooling system.

### BACKGROUND

Dry coolers and other heat exchanger systems operate to dissipate thermal energy from a cooling fluid (e.g., water) circulating therethrough to the ambient environment. For example, in a datacenter, a dry cooler can be used to cool heated water extracted from within the datacenter (e.g., water circulated through water blocks coupled to heat-generating electronic components).

In order to improve the efficiency of heat exchanger systems, some arrangements implement direct spray evaporative techniques to precool the temperature of the ambient air that flows through the heat exchanger system. For example, in some cases, a water spraying system (i.e., an atomizer) is placed at the air inlet of a dry cooler to spray water and increase the humidity level of the ambient air, thereby reducing its temperature. Other adiabatic cooling implementations also include for instance, evaporating pads in which water is applied to ambient air prior to entering the heat exchanger system or evaporating pads in which water is applied directly thereon.

However, in use, these implementations have experienced some drawbacks. For instance, these implementations typically employ a multitude of sensors, detectors, hardware, valves, and electronic components to control the water flow. Also, using direct spray techniques may consume a large volume of water, which negatively impacts the Water Usage Effectiveness (WUE) of such techniques and may also promote the dispersion of pathogenic bacteria, such as Legionella. Additionally, not all the water applied to the evaporating pads is absorbed and dissipated into the ambient air, thereby resulting in inconsistent cooling, temperature fluctuations, dust/contaminant buildup, and increased energy and water consumption to rectify these issues.

Therefore, even though the cooling implementations and techniques noted above provide certain benefits, further improvements that alleviate at least some of the drawbacks of these cooling implementations/techniques are still desirable.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on certain drawbacks associated with conventional dry cooling techniques and implementations.

In one aspect of the present technology, there is provided a datacenter dry cooling system for cooling a heat generating source, comprising a cooling liquid closed loop arrangement configured to convey and circulate a cooling liquid throughout the heat-generating source, the cooling liquid adapted to absorb the thermal energy of the heat-generating source resulting in a warmed liquid; at least one fan assembly configured to forcibly cause ambient air to flow throughout the dry cooling system; an air-to-liquid heat exchanger panel adapted to receive the warmed liquid, via the cooling liquid closed loop arrangement, and exposed to the forced ambient airflow; an evaporating pad, disposed at an input airflow side of the air-to-liquid heat exchanger panel, and configured to receive a controlled measured amount of cooling water that is to be evaporated while exposed to the forced ambient airflow in order to dissipate the thermal energy of the warmed liquid for recooling and recirculation, the evaporating pad incorporating at least one of a temperature sensor for detecting ambient temperature levels or a relative humidity sensor for detecting ambient humidity levels.

The datacenter dry cooling system further includes an evaporative cooling water distribution conduit configured to convey the evaporative cooling water throughout the cooling water distribution arrangement; a pump, fluidly-coupled to the evaporative cooling water distribution conduit, and configured to forcibly urge the flow of the evaporative cooling water throughout the evaporating cooling water distribution arrangement; a flow control valve, fluidly-coupled to the evaporative cooling water distribution conduit, and configured to control the conveyance of the evaporative cooling water; a volume flow sensor configured to detect the volume flow of the evaporative cooling water; and a controller, communicatively-coupled to the at least one of temperature sensor and relative humidity sensor, and configured to control the volume flow of the evaporative cooling water applied to the evaporating pad based, at least in part, on the data provided by the at least one of the temperature sensor and the relative humidity sensor.

In a related aspect of the present technology, there is provided a datacenter dry cooling method for cooling a heat-generating source, comprising receiving, by an air-to-liquid heat exchanger panel (20), warmed liquid heated by the heat-generating source, the air-to-liquid heat exchanger panel (20) configured to be exposed to forced ambient airflow; applying a controlled measured amount of cooling water to an evaporating pad (150), arranged on an input air flow side of the heat exchanger panel, that is to be evaporated while exposed to the forced ambient airflow in order to dissipate the thermal energy of the warmed liquid, the evaporating pad incorporating at least one of a temperature sensor (212B, 214B) for detecting ambient temperature levels or a relative humidity sensor (212A, 214A) for detecting ambient humidity levels; disposed at an input airflow side of the air-to-liquid heat exchanger panel (20), and configured to receive a controlled measured amount of cooling water that is to be evaporated while exposed to the forced ambient airflow in order to dissipate the thermal energy of the warmed liquid for recooling and recirculation, the evaporating pad incorporating at least one of a temperature sensor (212B, 214B) for detecting ambient temperature levels or a relative humidity sensor (212A, 214A) for detecting ambient humidity levels.

The datacenter dry cooling method further includes receiving, by a controller (500), the detected ambient temperature or humidity levels; increasing, by the controller, the volume flow rate of the applied cooling water to a maximum amount when it is determined that the received temperature level is greater than a first threshold temperature value; and decreasing, by the controller, the volume flow rate of the applied cooling water to a minimum amount when it is determined that the received temperature level is less than a second threshold temperature value.

In another related aspect of the present technology, there is provided a datacenter dry cooling and a method of operating a datacenter dry cooling in accordance with any of the appended claims.

Within the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid statedrives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1A illustrates a conceptual representation of a dry cooler unit, in accordance with the nonlimiting embodiments of the present technology;
FIG. 1B illustrates a high-level functional block general overview diagram of a dry cooling arrangement, in accordance with the nonlimiting embodiments of the present technology;
FIG. 2A illustrates an evaporative cooling water distribution arrangement, in accordance with the nonlimiting embodiments of the present technology;
FIG. 2B illustrates a cross-sectional view of an evaporative cooling pad and various sensors, in accordance with the nonlimiting embodiments of the present technology; and
FIG. 3 illustrates a functional flow diagram indicating the process operations executed by a monitoring controller of the evaporative cooling water distribution arrangement of FIG. 2A, in accordance with non-limiting embodiments of the present technology.

It should be appreciated that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the figures including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a generalpurpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

In certain aspects, the present technology provides a dry cooling arrangement. The dry cooling arrangement comprises a closed loop, a semi-open loop, and at least one fan. The closed loop comprises a primary side of a liquid-to-liquid heat exchanger, the primary side being receiving a first cooling fluid from a heat source, for instance heat generating units of a datacenter. The first cooling fluid may be, for example, water or any other suitable cooling fluid. The closed loop also comprises an air-to-liquid heat exchanger receiving the first cooling fluid from the primary side of the liquid-to-liquid heat exchanger. The air-to-liquid heat exchanger may be, for instance, a part of a dry cooler. The closed loop also comprises a first pump receiving the first cooling fluid from the air-to-liquid heat exchanger and returning the first cooling fluid to the heat source. The semi-open loop may also comprise a tank storing and supply a second cooling fluid or may also be configured to directly receive a second cooling fluid from a local municipal water source. The second cooling fluid may be, for example, water or any other suitable cooling fluid. The semi-open loop also comprises a second pump drawing the second cooling fluid from the tank and a secondary side of the liquid-to-liquid heat exchanger. The cooling arrangement comprises at least one fan causing outside air to flow through the evaporating pad and through the air-to-liquid heat exchanger.

Given this fundamental understanding, attention is directed to some non-limiting examples to illustrate various implementations of aspects of the present technology.

In the non-limiting disclosed embodiments of the present technology detailed below, a datacenter dry cooling system directed to cooling heat-generating electronic processing assemblies is presented. The dry cooling system incorporates an evaporating cooling water distribution arrangement for supplying evaporative cooling water to an evaporating pad of the dry cooling system. The dry cooling system further incorporates relatively humidity and/or temperature sensors to detect outside external ambient conditions as well as an electronic monitoring controller configured to control and provide the optimal volume flow of the evaporative cooling water applied to the evaporating pad based, at least in part, on the data provided by the temperature sensors and humidity sensors. In this manner, the disclosed embodiments provide an evaporative cooling water arrangement for a datacenter dry cooler unit that optimally controls the application of cooling water to evaporating pads to virtually prevent any cooling water leakages while, at the same time, substantially reducing the number of sensors, detectors, hardware, valves, and electronic components typically required by the prior art configurations to achieve the intended effect. This dry cooling arrangement further provides the added benefit of using an optimal amount of water to reduce large water consumption.

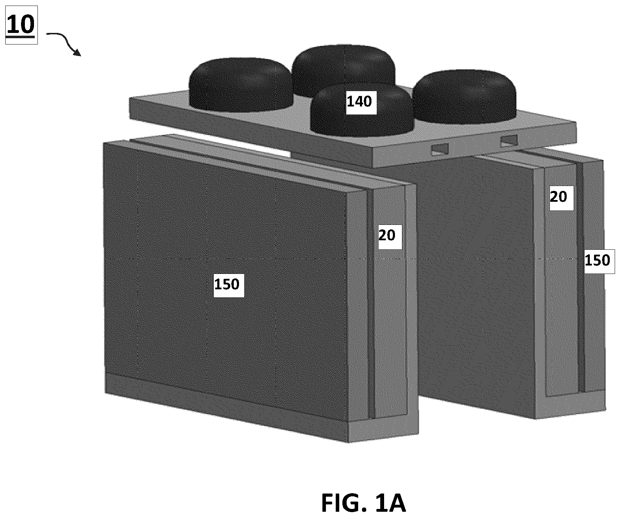

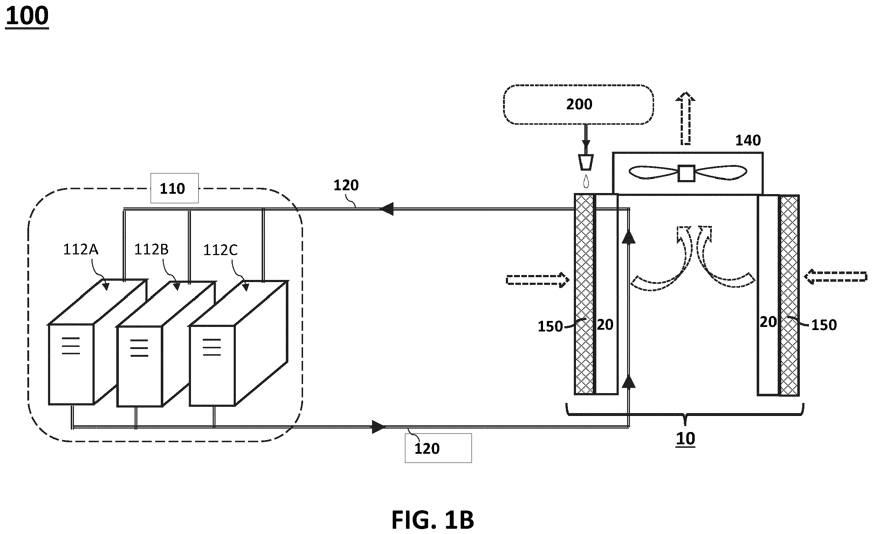

With this said, FIG. 1A illustrates a conceptual representation of a dry cooler unit **10** and FIG. 1B illustrates a high-level functional block general overview diagram of a dry cooling arrangement **100,** in accordance with the nonlimiting embodiments of the present technology. The dry cooler unit **10** may be located on any suitable support surface, such as, for example, the roof of a datacenter building or stable surface in close proximity to the datacenter. As shown, dry cooler unit **10** generally comprises the basic following components: at least one heat exchanger panel **20,** at least one fan assembly **140,** and at least one evaporating pad **150.**

The heat exchanger panel **20** operates to expel heated thermal energy of a cooling liquid, flowing through and warmed by rack-mounted heat-generating electronic processing assemblies, into the ambient environment. That is, the heat exchanger panel **20** is configured as a liquid-to-air heat exchanger, having an air inlet side *(not shown)* for receiving ambient air flow and an air outlet side *(not shown)* for expelling heated air. The heat exchanger panel **20** also incorporates cooling coils *(not shown),* in which warmed cooling liquid circulates therethrough via a cooling liquid closed loop **120.**

As indicated in FIG. 1B, the cooling liquid closed loop **120** conveys the cooling liquid to processing servers **112A-C** (collectively referred to as "heat source **110**") that house the rack-mounted heat-generating electronic processing assemblies *(not shown).* The cooling liquid is supplied to liquid cooling blocks *(not shown)* in direct thermal contact to the heat-generating electronic processing components for cooling purposes. The cooling liquid absorbs the generated heat and the warmed cooling liquid is circulated, via the cooling liquid closed loop **120** back to the dry cooler unit **10** for extracting and dissipating the thermal energy therein and recooling the cooling fluid. It will be appreciated that the cooling liquid may comprise water, dielectric fluid, refrigerant fluid, diphasic fluid, or any other fluid suitable for collecting and discharging thermal energy.

The fan assembly **140** is disposed on an upper surface of the dry cooler unit **10** and is configured to forcibly cause ambient air flow throughout the dry cooler **10.** The fan assembly **140** comprises a plurality of fans located at an upper end of the dry cooler **10.** The fan assembly **140** includes respective motors *(not shown)* that drive each of the fans to rotate and forcibly pull ambient air from a lateral side of the dry cooler **10** towards an interior space of the dry cooler unit **10.** The heat exchanger panel **20** (and respective cooling coils) is exposed to the forcibly pulled-in ambient air. In turn, the thermal energy manifested by the warmed first cooling liquid circulating through the cooling coils is transferred, via the outlet side, and expelled vertically upwards from the dry cooler unit **10** into the ambient environment.

The evaporating pad **150** is positioned to directly abut an outer lateral surface of the heat exchanger panel **20.** The evaporating pad **150** is configured to absorb a cooling liquid applied thereto while enabling air flow to pass through the pad surface. The evaporating pad **150** comprises an air inlet surface *(not shown)* for receiving the air flow and an air outlet surface *(not shown)* for expelling the air flow. The evaporating pad **150** may be made of plastic material, cellulose, glass fibers, *etc.* to absorb the applied cooling liquid.

As will be described in greater detail below, the evaporating pad **150** operates to receive cooling water from an evaporative cooling water distribution arrangement **200.** The evaporative cooling arrangement **200** is configured to apply a specifically-controlled measured amount of evaporative cooling water, based on certain detected operational factors, to wet the evaporating pad **150** for optimal cooling performance while virtually eliminating any water leakages.

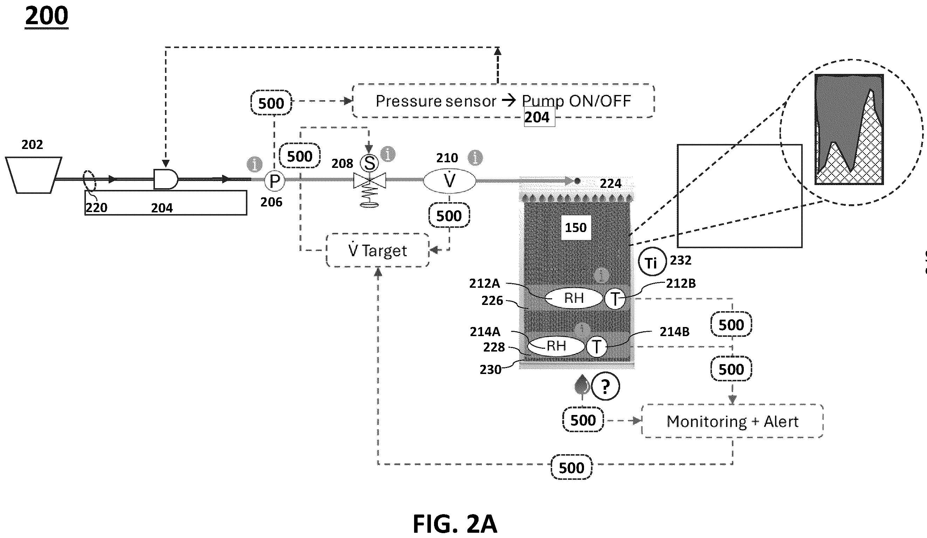

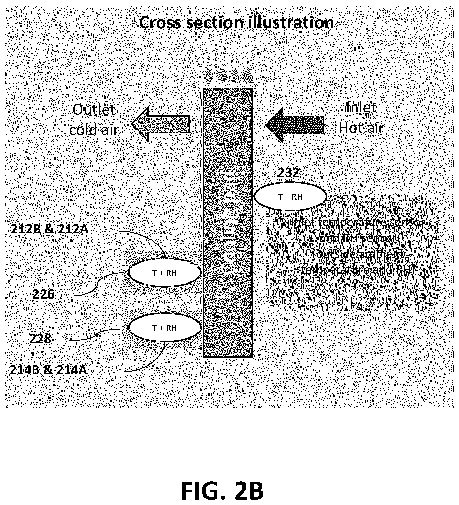

To this end, FIG. 2A and 2B illustrate an evaporative cooling water distribution arrangement **200,** in accordance with the nonlimiting embodiments of the present technology. The evaporative cooling water is supplied by source **202** via a distribution conduit **220** and a pump **204.** The pump **204** is configured to forcibly urge the flow of the evaporative cooling water throughout the distribution conduit **220.** It will be appreciated that the evaporative cooling water supplied by source **202** may comprise deionized water, osmosed water, or any other type of treated/processed water that is free from minerals or contaminants.

The pressure level of the flow of the evaporative cooling water is detected by pressure sensor **206.** As will be described in greater detail below, pressure sensor **206,** humidity sensors **212A, 214A,** temperature sensors **212B, 214B, 232** and volume sensor **210** are communicativecoupled to a monitoring controller **500** to report the respective detected water pressure data, relative humidity data, temperature data, and water flow data. The monitoring controller **500** is configured to process the data to determine whether the operations of certain components should remain the same, be subjected to adjustments, or turned off.

Provided that the pump **204** is allowed to continue operations, the distribution conduit **220** conveys the evaporative cooling water to a volume flow control valve **208.** The flow control valve **208** may comprise a solenoid-controlled valve, a pressure independent control valve (PICV), or an automatic balancing pressure control valve (ABQM). In an alternative configuration, a temperature sensor *(not shown)* that is communicatively-coupled to the valve **208** may be used instead of the pressure sensor **206** to actuate the pump **204.** That is, the pump **204** is actuated upon a threshold temperature level is detected by the temperature sensor. Subsequently, the evaporative cooling water flow exiting valve **208** is then detected by volume sensor **210.**

The distribution conduit **220** subsequently conveys the evaporative cooling water to a water distribution unit **224** configured to apply the cooling water to the evaporating pad **150.** The water distribution unit **224** may comprise a nozzle or a series of nozzles, a fluid discharge manifold, a sprayer, or any structure that uniformly dispenses the cooling water across the width dimension of a top surface of the pad **150.**

For purposes of illustration, the depicted embodiment indicates that the evaporating pad **150** is associated with humidity sensors **212A, 214A** and/or temperature sensors **212B, 214B** on the air outlet surface that measure the outside relative humidity and temperature levels that measures the temperature levels after the evaporative cooling pad. In various implementations, the evaporating pad **150** may be associated with only temperature sensors and only humidity sensors on the air outlet surface of the pad **150** or as will be described in greater detail below, a temperature sensor associated with a first band across the pad surface and a humidity sensor associated with a second band across the pad surface. In addition, there is provided an inlet temperature sensor **232** that measures the outside temperature before the evaporative cooling pad. Therefore, it should be appreciated that such alternative implementations are consistent with the scope of the disclosed concepts.

Returning to the illustrated embodiment of FIG. 2A, the air inlet and outlet surfaces of the evaporating pad **150** may implement a first monitoring band **226** across the width dimension of the evaporating pad **150** and a second monitoring band **228** across the width dimension of the evaporating pad **150** that is positioned lower than the first band **226.** By way of relative reference, the first monitoring band **226** is disposed below a halfway point of the evaporating pad **150** vertical dimension and the second monitoring band **228** is disposed below the first monitoring band **226** such that a spaced buffer band **230** is defined between the bottom of the second band **228** and the bottom surface of the evaporating pad **150.** The spaced buffer band **230** operates as an internal reservoir that absorbs any residual cooling water, via capillary action, from the bottom of the evaporating pad **150** that may otherwise result in leakages.

The relative positioning of the first and second monitoring bands **226, 228** noted above is based on the developer's observation that, while the cooling water is applied uniformly, the actual absorption of the cooling water is nonuniform throughout the evaporating pad **150.** That is, as conceptually represented in the circular insert of FIG. 2A, because of the material composition of the evaporating pad **150,** the absorption level of the cooling water along the pad is very irregular, as it varies along different areas of the evaporating pad **150.**

As best shown in the a cross-sectional view of FIG. 2B, the humidity sensor **212A** and/or temperature sensor **212B** are implemented along the first monitoring band **226** of the evaporating pad **150** while humidity sensor **214A** and/or temperature sensor **214B** are implemented along the second monitoring band **228** to report relative humidity and temperature data to the monitoring controller **500.** The implementation of humidity sensors **212A, 214A** and/or temperature sensors **212B, 214B** along the respective monitoring bands **226, 228** involves positioning the sensors at a predefined distance away from the evaporating pad **150,** surface so as not contact the pad **150.** For further clarity, the evaporating pad **150** being associated with humidity sensors **212A, 214A** and/or temperature sensors **212B** may be defined, in some embodiments, as a positioning of the humidity sensors **212A, 214A** and/or the temperature sensors **212B** proximate to, but not in contact with, the evaporating pad **150.** In some other embodiments, the evaporating pad **150** being associated with the humidity sensors **212A, 214A** and/or the temperature sensors **212B** may be defined as an incorporation of the humidity sensors **212A, 214A** and/or the temperature sensors **212B** within the evaporating pad **150.**

In this manner, the monitoring controller **500** is able to accurately monitor the relative humidity and temperature levels across the first and second monitoring bands **226, 228** in order to optimally control the application of cooling water to the evaporating pad **150** and virtually prevent any leakages dripping from the bottom of the evaporating pad **150.**

FIG. 2A also references that evaporative cooling water distribution arrangement **200** employs certain operations, such as pump control and monitoring/alert messaging as well as utilizes operational metrics, such as target volume flow V_{target}, Vₘᵢₙ, Vₘₐₓ, T_{mid}, T_{low-up}, and T_{low-down}. The metrics T_{mid}, T_{low-up}, and T_{low-down} may be a constant or a function of the outside humidity ***f***(RH) and/or temperature levels ***f***(T). These operational metrics are utilized by the monitoring controller **500** to optimally control the application of cooling water to the evaporating pad **150** and are derived from empirical data analyzed by the developers regarding outside relative humidity and/or outside temperature levels. Accordingly, a target volume V_{target} of the evaporative cooling water to be applied to the evaporating pad **150** may be formulated as a function of the outside relative humidity before the evaporative cooling pad (V_{target} = ***f***(RH)) and/or outside temperature levels before the cooling pad (V_{target} =***f***(T)) relative to a given heat load of the heat source **110** (*i.e.,* processing servers **112A-C**).

For purposes of clarity and tractability, the target volume V_{target} of the evaporative cooling water will be described in terms of the detected temperature levels (V_{target} = ***f***(T)). However, it should be appreciated that such temperature level descriptions equally apply to the utilization of detected relative humidity levels or a combination of both.

With this said, the detected outside temperature along the first monitoring band **226** is represented as T_{mid} while target temperature T_{mid-target} relates to predetermined coefficient temperature values. The detected outside temperature along the second monitoring band **228** is represented as T_{low} having a range from T_{low-down} to T_{low-up}. Relatedly, the minimum evaporative cooling water flow rate is represented as Vₘᵢₙ which constitutes a percentage of the volume V_{target} and the maximum evaporative cooling water flow rate is represented as Vₘₐₓ which constitutes a higher percentage of the volume V_{target}.

By way of operations, the evaporative cooling water distribution arrangement **200** functions to first actuate the pump **206** and control valve **208** is opened to allow the flow of evaporating cooling water throughout the system. The flow of cooling water is detected by volume sensor **210** and the cooling water is conveyed to the water distribution unit **224** for applying the cooling water to the evaporating pad **150.**

The cooling water is absorbed by the evaporating pad **150** in which the temperature **212B, 214B** and/or humidity sensors **212A, 214A** disposed along the respective evaporating pad bands **226, 228** detect temperature and/or humidity levels. The detected data from volume sensor **210,** temperature **212B, 214B** and/or humidity sensors **212A, 214A** are forwarded to the electronic monitoring controller **500.**

The electronic monitoring controller **500** operates to determine whether the detected temperature across the first band is greater than a threshold temperature value and, if so, the volume flow rate of the cooling water is increased to a predetermined maximum flow rate. The monitoring controller **500** then determines whether the temperature across the second band is less than a predetermined minimum temperature value and, if so, the volume flow rate of the cooling water is decreased to a predetermined minimum flow rate.

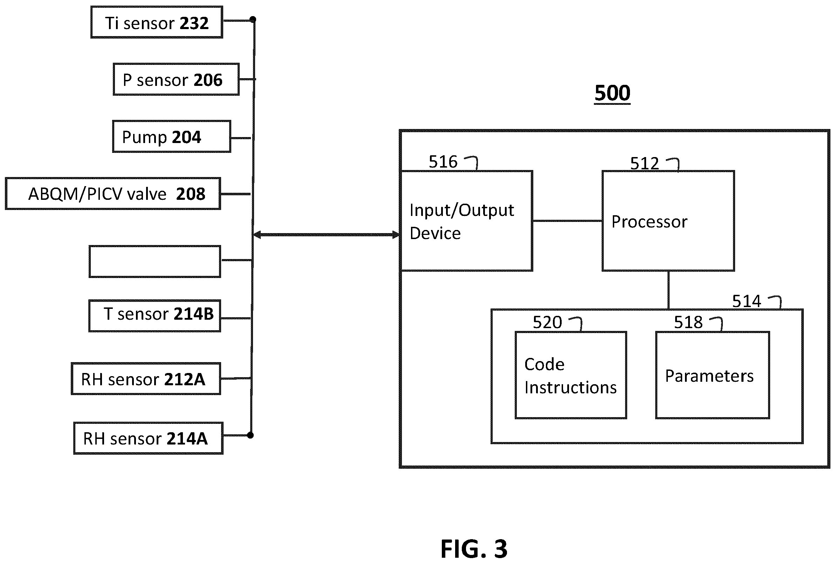

FIG. 3 illustrates a functional block diagram of monitoring controller **500,** in accordance with an embodiment of the present technology. As shown, the controller **500** comprises a processor or a plurality of cooperating processors (represented as a processor **512** for simplicity), a memory device or a plurality of memory devices (represented as a memory device **514** for simplicity), one or more input devices and one or more output devices, the input devices and the output devices being possibly combined in one or more input/output devices (represented as a single input/output device **516** for simplicity). The processor **512** is operatively connected to the memory device **514** and to the input/output device **516.** The memory device is configured to store a list **518** of relevant parameters. The memory device **514** may comprise a non-transitory computer-readable media for storing control logic instructions **520** that are executable by the processor **512** and, in particular, the executing process **300** for optimally controlling the application of cooling water to the evaporating pad **150.**

The processor **512** is communicatively coupled, via the input/output interface **516,** to the pressure sensor **206,** pump **204,** temperature sensors **212B, 214B** relative humidity sensors **212A, 214A** for extraction of relevant data as well as operatively coupled to ABQM/PICV valve **208** and pump **206** for adjustment and control of disclosed elements. The processor **512** is configured to execute the control logic instructions **520** stored in the memory device **514** to implement the various above-described functions of the controller **500.**

It will be appreciated that in certain embodiments, the control logic instructions **520** of processor **512** may be further configured to evaluate the detected data received from the sensors **206, 212A, 212B, 214A, 214B** over a period of time to provide predictive and/or recommended operating control parameters of operatively coupled elements such as valve **208** and pump **204.** As such, the control logic instructions **520** may incorporate artificial intelligence (AI) methodologies that analyze the operational parameters of all detected sensors over time to provide adjustments/control of related elements to optimize evaporative water cooling operations based on empirical/historical data, such as, for example, time of day, weekdays, weekends, different seasons, *etc.*

With this said, the disclosed non-limiting embodiments provide an evaporative cooling water arrangement for a datacenter dry cooler unit that is configured to optimally control the application of cooling water to evaporating pads and virtually prevents any cooling water leakages while, at the same time, substantially reducing the number of sensors, detectors, hardware, valves, and electronic components required to achieve the intended effect by prior art configurations. And, furthermore, the cooling water arrangement promotes efficient water usage by minimizing wasted water.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A datacenter dry cooling system (200) for cooling a heat-generating source (110), comprising:
a cooling liquid closed loop arrangement (120) configured to convey and circulate a cooling liquid throughout the heat-generating source (110), the cooling liquid adapted to absorb the thermal energy of the heat-generating source (110) resulting in a warmed liquid;
at least one fan assembly (140) configured to forcibly cause ambient air to flow throughout the dry cooling system (200);
an air-to-liquid heat exchanger panel (20) adapted to receive the warmed liquid, via the cooling liquid closed loop arrangement (120), and exposed to the forced ambient airflow;
an evaporating pad (150), disposed at an input airflow side of the air-to-liquid heat exchanger panel (20), and configured to receive a controlled measured amount of cooling water that is to be evaporated while exposed to the forced ambient airflow in order to dissipate the thermal energy of the warmed liquid for recooling and recirculation;
at least one of a temperature sensor (212B, 214B) for detecting ambient temperature levels and/or a relative humidity sensor (212A, 214A) for detecting ambient humidity levels;
an evaporating cooling water distribution arrangement (200) for supplying the evaporative cooling water to the evaporating pad (150), comprising:
an evaporative cooling water distribution conduit (220) configured to convey the evaporative cooling water throughout the cooling water distribution arrangement (200);
a flow control valve (208), fluidly-coupled to the evaporative cooling water distribution conduit (220), and configured to control the conveyance of the evaporative cooling water;
a volume flow sensor (210) configured to detect the volume flow of the evaporative cooling water; and
a controller (500), communicatively-coupled to the at least one of temperature sensor and/or relative humidity sensor (212A, 214A), and configured to control the volume flow of the evaporative cooling water applied to the evaporating pad (150) based, at least in part, on the data provided by the at least one of the temperature sensor and/or the relative humidity sensor (212A, 214A).

2. The datacenter dry cooling system of claim 1, further comprising a pump (204), fluidly-coupled to the evaporative cooling water distribution conduit (220), and configured to forcibly urge the flow of the evaporative cooling water throughout the evaporating cooling water distribution arrangement (200).

3. The datacenter dry cooling system of claim 2, further comprising a pressure sensor (206) configured to detect the pressure of the evaporative cooling water flow for controlling the actuation of the pump.

4. The datacenter dry cooling system of claim 2, further comprising a temperature sensor, communicatively-coupled to the valve (208), and configured to actuate the pump upon a detected temperature threshold level.

5. The datacenter dry cooling system of anyone of claims 1 to 4, wherein the flow control valve (208) comprises at least one of a solenoid-controlled valve, a pressure independent control valve (PICV), or an automatic balancing pressure control valve (ABQM).

6. The datacenter dry cooling system of anyone of claims 1 to 5, wherein the evaporating pad (150) comprises:
a first monitoring band (226) across the width dimension of the evaporating pad (150) that is associated with the at least one of the temperature and/or humidity sensor on an outlet surface of the evaporating pad; and
a second monitoring band (228) across the width dimension of the evaporating pad (150), positioned lower than the first band (226), that is associated with another of a temperature and/or humidity sensor on an outlet surface of the evaporating pad.

7. The datacenter dry cooling system of anyone of claims 1 to 6, further comprising an input temperature sensor (232) positioned on an inlet surface of the evaporating pad.

8. The datacenter dry cooling system of claim 6, wherein a spaced buffer band (230) is defined between the bottom of the second band (228) and the bottom surface of the evaporating pad (150).

9. The datacenter dry cooling system of anyone of claim 6 to 8, wherein the at least one of the temperature or humidity sensors associated with the respective bands register substantially the same temperature or humidity values along an air inlet surface and an air outlet surface of the evaporating pad.

10. A datacenter dry cooling method for cooling a heat-generating source, comprising:
receiving, by an air-to-liquid heat exchanger panel (20), warmed liquid heated by the heat-generating source, the air-to-liquid heat exchanger panel (20) configured to be exposed to forced ambient airflow;
applying a controlled measured amount of cooling water to an evaporating pad (150), arranged on an input air flow side of the heat exchanger panel, that is to be evaporated while exposed to the forced ambient airflow in order to dissipate the thermal energy of the warmed liquid, the evaporating pad being associated with at least one of a temperature sensor (212B, 214B) for detecting ambient temperature levels or a relative humidity sensor (212A, 214A) for detecting ambient humidity levels;
disposed at an input airflow side of the air-to-liquid heat exchanger panel (20), and configured to receive a controlled measured amount of cooling water that is to be evaporated while exposed to the forced ambient airflow in order to dissipate the thermal energy of the warmed liquid for recooling and recirculation;
receiving, by a controller (500), the detected ambient temperature or humidity levels;
increasing, by the controller, the volume flow rate of the applied cooling water to a maximum amount when it is determined that the received temperature level is greater than a first threshold temperature value; and
decreasing, by the controller, the volume flow rate of the applied cooling water to a minimum amount when it is determined that the received temperature level is less than a second threshold temperature value.

11. A datacenter dry cooling system (200) for cooling a heat-generating source (110), comprising:
a cooling liquid closed loop arrangement (120) configured to convey and circulate a cooling liquid throughout the heat-generating source (110), the cooling liquid adapted to absorb the thermal energy of the heat-generating source (110) resulting in a warmed liquid;
at least one fan assembly (140) configured to forcibly cause ambient air to flow throughout the dry cooling system (200);
an air-to-liquid heat exchanger panel (20) adapted to receive the warmed liquid, via the cooling liquid closed loop arrangement (120), and exposed to the forced ambient airflow;
an evaporating pad (150), disposed at an input airflow side of the air-to-liquid heat exchanger panel (20), and configured to receive a controlled measured amount of cooling water that is to be evaporated while exposed to the forced ambient airflow in order to dissipate the thermal energy of the warmed liquid for recooling and recirculation, the evaporating pad being associated with one or more temperature sensor (212B, 214B) for detecting ambient temperature levels or one or more relative humidity sensor (212A, 214A) for detecting ambient humidity levels;
an evaporating cooling water distribution arrangement (200) for supplying the evaporative cooling water to the evaporating pad (150), comprising:
an evaporative cooling water distribution conduit (220) configured to convey the evaporative cooling water throughout the cooling water distribution arrangement (200);
a flow control valve (208), fluidly-coupled to the evaporative cooling water distribution conduit (220), and configured to control the conveyance of the evaporative cooling water;
a volume flow sensor (210) configured to detect the volume flow of the evaporative cooling water; and
a controller (500), communicatively-coupled to the one or more temperature sensor or the one or more relative humidity sensor (212A, 214A), and configured to control the volume flow of the evaporative cooling water applied to the evaporating pad (150) based, at least in part, on the data provided by the temperature sensor or relative humidity sensor (212A, 214A).

12. The datacenter dry cooling system of claim 11, further comprising:
a pump (204), fluidly-coupled to the evaporative cooling water distribution conduit (220), and configured to forcibly urge the flow of the evaporative cooling water throughout the evaporating cooling water distribution arrangement (200); and
a pressure sensor (206) configured to detect the pressure of the evaporative cooling water flow for controlling the actuation of the pump.

13. The datacenter dry cooling system of claim 12 or 13, wherein the flow control valve (208) comprises at least one of a solenoid-controlled valve, a pressure independent control valve (PICV), or an automatic balancing pressure control valve (ABQM).

14. The datacenter dry cooling system of anyone of claims 12 to 14, wherein the evaporating pad (150) comprises:
a first monitoring band (226) across the width dimension of the evaporating pad (150) that is associated with at least one of the temperature or humidity sensor on an outlet surface of the evaporating pad; and
a second monitoring band (228) across the width dimension of the evaporating pad (150), positioned lower than the first band (226), that is associated with at least another one of the temperature or humidity sensor on an outlet surface of the evaporating pad.

## Amended claims

### Amended claims in accordance with Rule 137(2) EPC.

1. A datacenter dry cooling system (200) for cooling a heat-generating source (110), comprising:
a cooling liquid closed loop arrangement (120) configured to convey and circulate a cooling liquid throughout the heat-generating source (110), the cooling liquid adapted to absorb the thermal energy of the heat-generating source (110) resulting in a warmed liquid;
at least one fan assembly (140) configured to forcibly cause ambient air to flow throughout the dry cooling system (200);
an air-to-liquid heat exchanger panel (20) adapted to receive the warmed liquid, via the cooling liquid closed loop arrangement (120), and exposed to the forced ambient airflow;
an evaporating pad (150), disposed at an input airflow side of the air-to-liquid heat exchanger panel (20), and configured to receive a controlled measured amount of cooling water that is to be evaporated while exposed to the forced ambient airflow in order to dissipate the thermal energy of the warmed liquid for recooling and recirculation;
at least one of a temperature sensor (212B, 214B) for detecting ambient temperature levels and/or a relative humidity sensor (212A, 214A) for detecting ambient humidity levels, the at least one temperature sensor (212B, 214B) and at least one relative humidity sensor (212A, 214A) disposed at an output airflow side surface of the air-to-liquid heat exchanger panel (20);
an evaporating cooling water distribution arrangement (200) for supplying the evaporative cooling water to the evaporating pad (150), comprising:
an evaporative cooling water distribution conduit (220) configured to convey the evaporative cooling water throughout the cooling water distribution arrangement (200);
a flow control valve (208), fluidly-coupled to the evaporative cooling water distribution conduit (220), and configured to control the conveyance of the evaporative cooling water;
a volume flow sensor (210) configured to detect the volume flow of the evaporative cooling water; and
a controller (500), communicatively-coupled to the at least one of temperature sensor (212B, 214B) and/or relative humidity sensor (212A, 214A), and configured with executable logic instructions to control the volume flow of the evaporative cooling water applied to the evaporating pad (150) based, at least in part, on the data provided by the at least one of the temperature sensor (212B, 214B) and/or the relative humidity sensor (212A, 214A),
wherein, the evaporating pad (150) incorporates a first monitoring band (226) across the width dimension of the evaporating pad (150) that is associated with the at least one of the temperature and/or humidity sensor (212B, 212A) on the output airflow side surface of the evaporating pad and a second monitoring band (228) across the width dimension of the evaporating pad (150), positioned lower than the first band (226), that is associated with another of a temperature and/or humidity sensor (214B, 214A) on the output airflow side surface of the evaporating pad.

2. The datacenter dry cooling system of claim 1, wherein the controller (500) is further configured to increase the volume flow rate of the applied cooling water to a maximum amount when it is determined that the received temperature level is greater than a first threshold temperature value and decrease the volume flow rate of the applied cooling water to a minimum amount when it is determined that the received temperature level is less than a second threshold temperature value.

3. The datacenter dry cooling system of claims 1 or 2, further comprising a pump (204), fluidly-coupled to the evaporative cooling water distribution conduit (220), and configured to forcibly urge the flow of the evaporative cooling water throughout the evaporating cooling water distribution arrangement (200).

4. The datacenter dry cooling system of anyone of claims 1 to 3, further comprising a pressure sensor (206) configured to detect the pressure of the evaporative cooling water flow for controlling the actuation of the pump.

5. The datacenter dry cooling system of anyone of claims 1 to 4, further comprising a temperature sensor, communicatively-coupled to the flow control valve (208) and configured to actuate the pump upon a detected temperature threshold level.

6. The datacenter dry cooling system of anyone of claims 1 to 5, wherein the flow control valve (208) comprises at least one of a solenoid-controlled valve, a pressure independent control valve (PICV), or an automatic balancing pressure control valve (ABQM).

7. The datacenter dry cooling system of anyone of claims 1 to 6, further comprising an input temperature sensor (232) positioned on an inlet surface of the evaporating pad.

8. The datacenter dry cooling system of anyone of claims 1 to 7, wherein a spaced buffer band (230) is defined between the bottom of the second monitoring band (228) and the bottom surface of the evaporating pad (150).

9. The datacenter dry cooling system of anyone of claims 1-7, wherein the at least one of the temperature or humidity sensors associated with the respective bands register substantially the same temperature or humidity values along an air inlet surface and an air outlet surface of the evaporating pad.

10. The datacenter dry cooling system of anyone of claims 1 to 9, wherein the executable logic instructions of the controller (500) include evaluating the detected data received by the sensors over a period of time to provide predictive operational parameters for control of at least the flow control valve (208).

11. A datacenter dry cooling method for cooling a heat-generating source, comprising:
receiving, by an air-to-liquid heat exchanger panel (20), warmed liquid heated by the heat-generating source, the air-to-liquid heat exchanger panel (20) configured to be exposed to a forced ambient airflow;
applying a controlled measured amount of cooling water to an evaporating pad (150), arranged on an input air flow side of the heat exchanger panel, that is to be evaporated while exposed to the forced ambient airflow in order to dissipate the thermal energy of the warmed liquid for recooling and recirculation, the evaporating pad being associated with at least one of a temperature sensor (212B, 214B) for detecting ambient temperature levels or a relative humidity sensor (212A, 214A) for detecting ambient humidity levels, the evaporating pad (150) incorporating a first monitoring band (226) across the width dimension of the evaporating pad (150) having at least one of a temperature and/or humidity sensor (212B, 212A) on an output airflow side surface of the evaporating pad and a second monitoring band (228) across the width dimension of the evaporating pad (150), positioned lower than the first band (226), having another temperature and/or humidity sensor (214B, 214A) on the output airflow side surface of the evaporating pad;
receiving, by a controller (500) configured with executable logic instructions, the detected data levels by the ambient temperature (212B, 214B) or humidity (212A, 214A) sensors;
increasing, by the controller, the volume flow rate of the applied cooling water to a maximum amount when it is determined that the received temperature level is greater than a first threshold temperature value; and
decreasing, by the controller, the volume flow rate of the applied cooling water to a minimum amount when it is determined that the received temperature level is less than a second threshold temperature value.

12. The datacenter dry cooling method of claim 11, wherein the controller (500) is communicatively-coupled to a flow control valve (208) configured to increase/decrease the volume flow rate of the applied cooling water to maximum/minimum amounts, in accordance with received controller instructions.

13. The datacenter dry cooling method of claims 11 or 12, wherein the executable logic instructions of the controller (500) include evaluating the detected data received by the sensors over a period of time to provide predictive operational parameters for control of at least the flow control valve (208).
